# EUROPÄISCHE PATENTSCHRIFT

(11) **EP 3 797 441 B1**
(45) Veröffentlichungstag und Bekanntmachung des Hinweises auf die Patenterteilung: **08.06.2022**
(21) Anmeldenummer: 19745981.1
(22) Anmeldetag: 08.07.2019
(51) Int. Cl.: H01L 51/42

(54) **METALLORGANISCHE PEROWSKIT-SOLARZELLE, TANDEM-SOLARZELLE SOWIE HERSTELLUNGSVERFAHREN DAZU**
ORGANOMETALLIC PEROVSKITE SOLAR CELL, TANDEM SOLAR CELL, AND MANUFACTURING PROCESS THEREFOR
CELLULE SOLAIRE À BASE DE PÉROVSKITE ORGANOMÉTALLIQUE, CELLULE SOLAIRE TANDEM ET PROCÉDÉ DE FABRICATION ASSOCIÉ

(30) Priorität: 24.07.2018 DE 102018212305
(43) Veröffentlichungstag der Anmeldung: 31.03.2021
(73) Patentinhaber: Siemens Energy Global GmbH & Co. KG, 81739 München (DE)
(72) Erfinder: AKIN, Seckin, 70100 Karaman (TR); FLEISCHER, Maximilian, 85635 Höhenkirchen (DE); GRÄTZEL, Michael, CH-1025 St-Sulpice (CH); KIM, Hui-Seon, 1004 Lausanne (CH); SEO, Jiyoun, 1020 Renens VD (CH); SIMON, Elfriede, 80639 München (DE); ZAKEERUDDIN, Shaik Mohammed, 1030 Bussigny (CH)
(86) Internationale Anmeldenummer: PCT/EP2019/068247
(87) Internationale Veröffentlichungsnummer: WO 2020/020620

(56) Entgegenhaltungen:
- WO-A1-2018/005749
- DE-A1-102015 121 844
- US-A1- 2015 295 194

## Beschreibung

Die Erfindung betrifft eine metallorganische Perowskit-Solarzelle, insbesondere eine mit einer Blei- oder Zinnhaltigen metallorganischen Photonen-Absorberschicht, sowie ein Herstellungsverfahren dafür.

Bekannt sind, beispielsweise aus der EP 2498315 A2, organische Solarzellen, auch Plastiksolarzellen genannt, die im Gegensatz zu den anorganischen Solarzellen auf flexible Substrate und Filme aufgebaut werden können.

Seit der Demonstration der ersten organischen Solarzelle mit einem Wirkungsgrad im Prozentbereich werden organische Materialien intensiv für verschiedene elektronische und optoelektronische Bauelemente verwendet. Organische Solarzellen bestehen aus einer Folge dünner Schichten, die typischerweise zwischen 1nm bi 100 µm aufweisen. Der Bandgap von geeigneten Absorberschichten liegt beispielsweise bei zumindest 1 eV.

Dabei gab es auch schon vielfältige Untersuchungen zu geeigneten Dotierungsmittel für die an die Absorberschicht angrenzenden Ladungsträgertransportschichten wie die Lochleiterschicht und die Elektronentransportschicht. Beispielsweise sei dazu die EP 2443680, DE 102011003192, DE 102012209520, DE 102014210412 sowie die DE 102015121844.

Organische Solarzellen sind schon Gegenstand vielfältiger Untersuchungen gewesen, da die Aussicht, ganze Verglasungen von Hochhäusern durch Beschichtung mit organischen Solarzellen zur Stromerzeugung nutzbar zu machen, weltweit sehr verlockend ist.

Die bekannten Plastik-Solarzellen haben als Material für die Absorberschicht konjugierte Polymere - KohlenwasserstoffPolymere in Kombination mit small molecules, beispielsweise Fullerenen, zur Ladungstrennung.

Bekannt ist auch aus der WO 2014/020499 ein Aufbau für eine metallorganische Perowskit-Solarzelle, bei der eine oder mehrere organisch-anorganische, hier auch als "metallorganisch" bezeichnete - Perowskit-Schichten zwischen zwei Kontaktschichten, beispielsweise Elektroden, mit denen die Perowskit-Schichten in elektrischem, vorzugsweise galvanischem Kontakt sind, angeordnet sind.

Durch den Einsatz metallorganischer Absorberschichten anstelle der rein organischen Absorberschichten, wie oben beschrieben, ergeben sich neue Herausforderungen für die Schichtabfolge der metallorganischen Solarzelle.

In der WO 2014/020499 wird noch davon ausgegangen, dass durch die metallorganische Absorberschicht eine Lochtransportschicht, wie sie in den organischen Solarzellen zwischen der Absorberschicht und der Elektrode vorgesehen ist, obsolet wird.

Das hat sich jedoch als nachteilig herausgestellt, so dass mittlerweile auch die metallorganische Solarzelle mit einer Absorberschicht eines im Perowskit-Kristallgitter kristallisierenden metallorganischen Materials zum schnelleren Abtransport der durch Photoneneinstrahlung getrennten Ladungsträger mit zumindest einer angrenzenden Lochtransportschicht realisiert wird.

So ist aus den EP 2898553 A1, WO 2018/005749 A1, und US 2015/295194 A1 eine metallorganische "p-i-n"-geschaltete Solarzelle bekannt, deren Schichtabfolge zumindest die folgenden Schichten umfasst: Transparente Elektrode, darauf ein Lochtransportmaterial, dann die Absorberschicht mit einem im dreidimensionalen Perowskit-Gitter kristallisierenden metallorganischen Absorbermaterial ABX₃, dann eine Elektronentransportschicht und die Gegenelektrode. Eine in einer hier beschriebenen Solarzelle nutzbare Lochtransportschicht ist beispielsweise aus "2,2'7,7'-tetrakis-(N, N-di-p-methoxyphenylamine)9,9'-spirobifluorene" oder kurz "SpiroOMeTad" mit sehr hohen - beispielsweise 30 Mol% und höher - Konzentrationen an einem schwachen Dotierungsmittel, das Lithium-Ionen enthält.

Der Einsatz solch hoher Dotierungs-Konzentrationen von Lithium in einer metallorganischen Solarzelle bringt jedoch den Nachteil, dass diese Schichten stark hygroskopisch sind und nur geringe Stabilität aufweisen.

Aufgabe der vorliegenden Erfindung ist es daher, anstelle oder ergänzend zum bekannten Lithium-haltigen p-Dotierungsmittel alternative p-Dotierungsmittel zur Verfügung zu stellen, deren Stabilität innerhalb der Lochleiterschicht und der gesamten metallorganischen Solarzelle höher ist. Diese Aufgabe wird durch den Gegenstand der vorliegenden Erfindung, wie er aus der Beschreibung, der Figur und den Ansprüchen offenbart wird, gelöst.

Dementsprechend ist Gegenstand der vorliegenden Erfindung eine metallorganische Solarzelle, zumindest zwei Kontaktschichten und daran angrenzend jeweils eine halbleitende Schicht in einem Schicht-Stapel mit einer mittig angeordneten Absorberschicht aus einem metallorganischen Material, das im dreidimensionalen Perowskit-Kristallgitter kristallisiert, aufweisend, wobei die Absorberschicht Blei und/oder Zinn als Zentralatom und ein Halogenid als Anion in einer metallorganischen Verbindung umfasst, dadurch gekennzeichnet, dass die zumindest eine halbleitende Schicht zwischen der Absorberschicht und der Anode eine lochleitende Schicht ist, die ein Zink- und/oder Bismut-haltiges Dotierungsmittel umfasst.

Außerdem ist Gegenstand der Erfindung eine Tandem-Solarzelle, entweder zwei metallorganische Solarzellen oder zumindest eine metallorganische Solarzelle mit einem Zink- und/oder Bismut-haltigem Dotierungsmittel in der Lochleiterschicht umfassend.

Schließlich ist Gegenstand der Erfindung ein Verfahren zur Herstellung eines Schichtkörpers, eine Tandem-Solarzelle bildend, bei dem ein Schichtstapel zwei Solarzellen umfassend, vorliegt, wobei eine untere und eine obere Solarzelle durch die Herstellung aufeinander folgender Schichten hergestellt werden, dadurch gekennzeichnet, dass zumindest eine der Solarzellen eine metallorganische Solarzelle, wie sie Gegenstand der Erfindung ist, ist.

Als metallorganische Verbindung wird vorliegend eine so genannte Komplex-Verbindung bezeichnet. Beispielsweise die im Perowskit-Kristallgitter kristallisierende Verbindung CH₃NH₃PbI₃ ist ein Paradefall einer solchen Verbindung. Im Kristallgitter kann man eine Elementarzelle erkennen, bei der das Blei mittig als so genanntes Zentralatom in einem Kubus sitzt, wobei die organischen Liganden, wie beispielsweise das CH₃NH₃ die acht Ecken des Kubus, also eines Würfels, bilden. Jeweils mittig in der Fläche des Würfels sitzt dann ein Anion, beispielsweise also ein Halogenid-Anion, wie das Jodid. Wenn im Kristallgitter viele solche Zellen aneinandergrenzen, dann resultiert in der Stöchiometrie eine Summenformel von CH₃NH₃PbI₃.

Bezüglich der Tandem-Solarzelle hat es sich als vorteilhaft erwiesen, dass in der Tandem-Solarzelle die zwei Solarzellen aufeinander hinsichtlich ihres Absorptionsspektrums abgestimmt sind, so dass ein maximales Strahlenspektrum absorbiert wird. Dabei ist insbesondere vorteilhaft, wenn die Tandem-Solarzelle aus zwei metallorganischen Solarzellen gebildet ist, beispielsweise dadurch, dass die beiden Solarzellen sich in der Zusammensetzung des Materials, das die Absorberschicht bildet, unterscheiden.

Abgesehen davon hat sich die Kombination einer metallorganischen Solarzelle, wie sie Gegenstand der Erfindung ist, mit einer c-Si-Solarzelle, auch als vorteilhaft erwiesen. Eine c-Si Solarzelle, ist eine Solarzelle, die kristallines Silizium in der Absorberschicht umfasst. Dabei liegt die metallorganische Solarzelle bevorzugt oben, näher an der Sonne.

Insbesondere wird beispielsweise die c-Si-Solarzelle als Substrat zum Aufbau einer metallorganischen Solarzelle wie sie Gegenstand der Erfindung ist, eingesetzt.

Die einzelnen Schichten des Schichtkörpers, der eine metallorganische Solarzelle oder eine Tandem-Solarzelle mit einer metallorganischen Solarzelle, bildet, können im nasschemischen Verfahren, beispielsweise durch Spin-Coating, beispielsweise aber nicht zwingend mit Lösungsmittel, hergestellt werden. Alternativ ist eine Herstellung über Dampfabscheidung, chemisch oder physikalisch, möglich.

Allgemeine Erkenntnis der Erfindung ist es, dass entgegen den Erwartungen, die eine Dotierung mit Zink- und/oder Bismut-Verbindungen in einer spiro-OMeTAD Lochleiterschicht angrenzend an eine Perowskit-Absorberschicht aus Blei- und/oder Zinn-Komplexverbindungen als instabil erwarten lassen, sich aus Zink- und/oder Bismut-salzen mit - beispielsweise - Supersäuren, stabile Dotierungsmittel für stabile Lochleiterschichten herstellbar sind.

Das Dotierungsmittel umfasst vorteilhafterweise neben dem Zink- und/oder Bismut-Kation noch ein Anion einer Supersäure.

Die Lochleiterschicht umfasst dabei zumindest eine Matrix und ein Dotierungsmittel, letzteres hier auf Zink- und/oder Bismut-Basis. Die Zugabe üblicher Additive ist allerdings auch vom Umfang der Erfindung mit umfasst.

Ein geeignetes Matrix-Material für die Lochtransportschicht einer metallorganischen Perowskit-Solarzelle ist beispielsweise ein organischer Leiter, beispielsweise das "2,2'7,7'-tetrakis-(N, N-di-p-methoxyphenylamine)9,9'-spirobifluorene" oder "spiro-OMeTAD". Durch Messungen konnte gezeigt werden, dass geringe Konzentrationen, wie beispielsweise 0,05 bis 10 mol%, insbesondere 0,1 bis 7 mol% und bevorzugt sogar nur 0,1 bis 2 mol% eines Dotierungsmittels, das Zink und/oder Bismut enthält, in einer spiro-OMeTAD Schicht genügen, um die nötigen Stromdichten in der Lochleiterschicht der Solarzelle zu erzeugen.

Bei der Abscheidung der Lochleiterschicht nasschemisch, das heißt aus Lösung wird insbesondere die Dotierkonzentration über den Massenanteil beispielsweise eines Supersäurensalzes und den Massenanteil des Matrixmaterials in der Lösung vor der Abscheidung eingestellt. Die Volumenkonzentration des p-Dopanten in der fertig abgeschiedenen Lochleiterschicht kann von dieser Konzentration abweichen.

Mit der erfindungsgemäßen Materialklasse der Zink- und/oder Bismut-Salzen, beispielsweise von Supersäuren, als Dotierungsmittel ist zur Herstellung der einzelnen Schichten des Schichtstapels eine nasschemische Abscheidemethode gegenüber der Abscheidung aus der Gasphase bevorzugt.

Besonders die photonenabsorbierenden Eigenschaften für den Einsatz des p-Dotiermittels in metallorganischen Solarzellen können durch die neuen Materialien für p-Dotierung stark verbessert werden. Eine hohe Leitfähigkeit wird schon bei geringen Dotierkonzentrationen erreicht.

Nicht einschränkende Beispiele für Supersäuren im Rahmen der vorliegenden Anmeldung sind:

### Anorganisch:

- Fluorsulfonsäure (HSO₃F)
- Fluor-Antimonsäure (HSbF₆)
- Tetrafluoroborsäure (HBF₄)
- Hexafluorophosphorsäure (HPF₆)
- Trifluoromethylsulfonsäure (HSO₃CF₃)

### Organisch:

- Pentacyanocyclopentadien (HC₅(CN)₅)
- Teilweise oder ganz fluorierte Derivate des Pentaphenylcyclopentadiens
- Penta-trifluoromethyl-pentadiens bzw. analoger Derviate
- Teilweise oder ganz fluorierte Derivate der Tetraphenylborsäure bzw. deren Cyanoderivate
- Teilweise oder ganz fluorierte Derivate der Arylsulfonsäuren bzw. deren Cyanoderivate
- Teilweise oder ganz fluorierte Derivate der Arylphosphonsäuren bzw. deren Cyanoderivate
- Anionen der Carborane wie beispielsweise [C₂B₁₀H₁₀]²⁻ oder [C₁B₁₁H₁₀]⁻

Die Trifluoromethylsulfonsäure (HSO₃CF₃) ist davon ein besonders geeigneter Vertreter.

Polymere Matrixmaterialien für Lochtransporter, die nasschemisch zur Herstellung der Lochleiterschicht der Solarzelle abgeschieden werden können, sind, neben dem bereits erwähnten "2,2'7,7'-tetrakis-(N, N-di-p-methoxyphenylamine)9,9'-spirobifluorene" oder "spiro-OMeTAD" insbesondere auch:
PEDOT (Poly(3,4 ethylenedioxythiophene))
PVK (poly(9-vinylcarbazole))
PTPD (poly (N.N₋bis (4-butylphenyl)-N,N-bis (phenyl)-benzidine))
P3HT (poly(3-hexylhtiophene))
PANI (polyaniline)
PTAA (Poly[bis(4-phenyl) (2,4,6-trimethylphenyl)amine]) sowie
9,9-Bis[4-(N,N-bis-biphenyl-4-yl-amino)phenyl]-9H-fluorene und/oder
4,4',4"-Tris(N-(2-naphthyl)-N-phenyl-amino)triphenylamine.

Im Sinne der Erfindung sind auch Mischungen aus den genannten polymeren Lochtransportmaterialien.

Als Lösungsmittel für die nasschemische Verarbeitung kommen bevorzugt organische Lösungsmittel zum Einsatz, wie zum Beispiel:
- Benzol,
- Chlorbenzol,
- Chloroform,
- Toluol,
- THF,
- Methoxypropylacetat,
- Anisol,
- Acetonitril,
- Phenetol oder
- Dioxan.

Ein weiterer besonderer Vorteil der Erfindung besteht darin, dass die für die p-Dotierung geeignete Materialklasse der Supersäurensalze mit der Lochleiter-Matrix aus dem gleichen Lösungsmittel abscheidbar ist. Dies stellt eine signifikante Vereinfachung der Abscheideverfahren für die Herstellung der metallorganischen Solarzelle dar.

Hinzu kommt, dass sich mit den Zink- und/oder Bismut-Salzen als Dotierungsmittel die Dotierung der Lochleiterschicht leichter herstellen lässt, insbesondere bei geringerer Prozesstemperatur, als die bereits bekannte, mit Lithium dotierten Lochtransportschichten. Die Temperatur ist bei der Herstellung der metallorganischen Solarzelle ein ganz heikler Faktor, weil die organischen Liganden und die Kristallstruktur natürlich gegenüber Temperaturerhöhung höchst sensibel reagieren. Des Weiteren wird bei diesen Dotiermaterialien keine Anwesenheit von Sauerstoff bei der Prozessierung zur Erzielung des Dotiereffekts benötigt. Dies ist vorteilhaft, da Sauerstoff sich negativ auf andere Teile des Schichtsystems der metallorganischen Solarzelle auswirkt. Beispielsweise die Herstellung einer mit Lithium-haltigem Dotierungsmittel versetzten Lochleiterschicht erfordert den Einsatz von Additiven wie tert-butylpyridine - TBP -. Dies führt zusammen mit der starken Hygroskopie der Lithium-Verbindungen zu einer indirekten Oxidation durch Luftsauerstoff.

Nach einer vorteilhaften Ausführungsform der Tandem-Solarzelle ist die metallorganische Solarzelle die obere Solarzelle, auf die die Photonen als erstes auftreffen. Hierbei gibt es zwei Ausführungsformen - 2 Terminal und 4 Terminal Strukturen einer Tandemzelle, jeweils abhängig von der Anzahl der Kontaktstellen der Tandem-Solarzelle.

Als Absorberschicht der metallorganischen Solarzelle wird bevorzugt eine Schicht mit einer ABX₃-Stöchiometrie eingesetzt, die im dreidimensionalen Perowskit-Kristallgitter kristallisiert.

Beispielsweise wird als metallorganische ABX₃ - Verbindung ein CH₃NH₃PbX₃ und/oder CH₃NH₃SnX₃ eingesetzt, wobei X ein Halogenid oder Pseudohalogenid, beispielsweise ausgewählt aus der Gruppe umfassend Fluorid, Chlorid, Cyanid, Isocyanid, Bromid und/oder Jodid, sowie beliebige Kombinationen davon, sein kann. Der Perowskite Absorber kann sehr unterschiedlich zusammengesetzt sein und beispielsweise so genannte "mixing cations" wie MA, FA und/oder Cs umfassen.

Die Halogenide/Pseudohalogenide liegen dabei als Anionen im Kristallgitter vor, der organische Ligand "(CH₃NH₃)⁺-, ebenso wie das Blei oder Zinn, als Kationen. Das Material der Absorberschicht kann auch -teilweise oder ganz- andere Verbindungen, wie z.B. die nachfolgend in einer nicht abschließenden Aufzählung genannten, umfassen:
FA_{0.81}Cs_{0.15}PbI_{2.51}Br_{0.45}
FA_{0.9}Cs_{0.1}PbI₃
Cs_{0.05}MA_{0.1}FA_{0.85}Pb(I_{0.85}Br_{0.15})₃
Cs_{0.05}MA_{0.1}FA_{0.85}Pb(I_{0.85}Br_{0.15})₃

Im Sinne der Erfindung sind auch Mischungen der genannten Verbindungen für das Absorbermaterial.

Überraschend hat sich herausgestellt, dass der Ersatz von Lithium durch Zink und/oder Bismut im Dotierungsmittel, respektive in der Lochleiterschicht, nicht nur die Stabilität der Lochleiterschicht um einiges erhöht, sondern erste Tests haben auch gezeigt, dass die Zink- und/oder Bismut-Dotierungsmittel auch schon in wesentlich geringeren Konzentrationen in den lochleitenden Schichten auch zu höheren Leerlaufspannungen, einem hohen Füll Faktor und einer deutlich höheren Photon-Konversions-Effizienz (PCE) der Solarzellen führen. Offensichtlich ist beispielsweise Zn(TFSI)₂ aktiver als LiTFSI in der Lochleitschicht, beispielsweise in spiro-MeOTAD, es leitet die Ladungsträger schneller und führt darin zu höheren Niveaus freier Ladungsträger.

Messungen an der EPFL, Lausanne, haben gezeigt, dass die hier erstmals im Zusammenhang mit spiro-MeOTAD eingesetzten TFSI Derivate von Zink und Bismut, signifikante elektrische Verbesserungen in der Lochleiterschicht erzeugen, die nicht allein durch verbesserte Leitfähigkeit erklärbar sind.

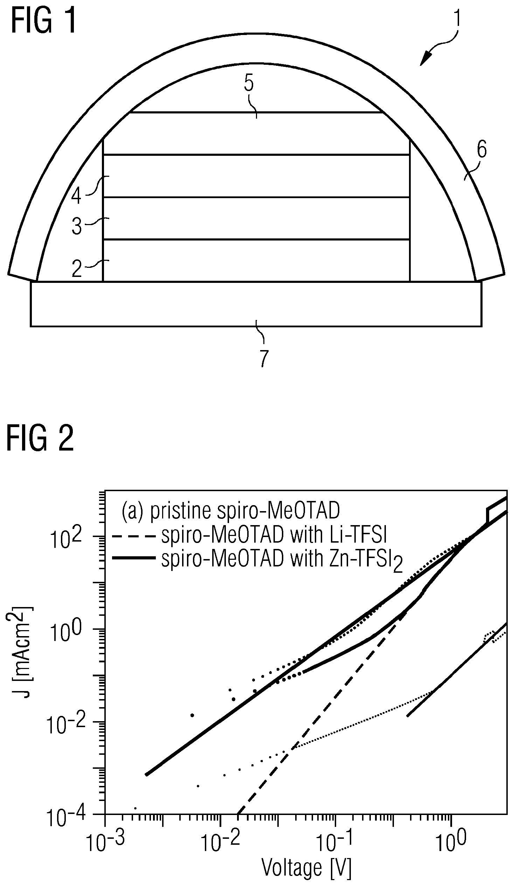

Figur 1 zeigt den Aufbau einer metallorganischen Solarzelle 1, im n-i-p-Layout, zumindest folgende Schichten umfassend: Eine transparente leitfähige Elektrode 7, wie beispielsweise eine Elektrode aus dotiertem Indium Zinn Oxid oder einer anderen transparenten leitfähigen Schicht. Diese kann auf einem Träger wie beispielsweise Glas aufgebracht sein oder selbsttragend ausgebildet sein.

Auf dieser Schicht ist eine n-leitende Schicht 2, beispielsweise aus Titandioxid. Darauf befindet sich die Absorberschicht, beispielsweise die Schicht 3 aus CH₃NH₃PbI₃ und/oder CH₃NH₃SnI₃ in der dreidimensionalen Perowskit-Struktur vorliegend. Die Absorberschicht 3 kann dabei planar oder in Form einer Gerüststruktur vorliegen. Angrenzend an diese Schicht befindet sich die Lochtransportschicht 4, die vorliegend aus einem Matrixmaterial, beispielsweise dem spiro-MeOTAD mit einem Dotierungsmittel, das Zink und/oder Bismut enthält, insbesondere mit Zn(TFSI)2 und/oder Bi(TFSI)3, wie es aus der DE 10 2015 121844 bekannt ist, ist.

Im Falle des Dotierungsmittels Zn (TFSI)₂ und/oder Bi(TFSI)₃ ist nach einer vorteilhaften Ausführungsform zwischen der Lochleiterschicht 4 und der Absorberschicht 3 noch eine dünne Sperrschicht, hier nicht gezeigt, vorgesehen. Dies kann vorteilhaft sein, falls das Dotierungsmittel die Tendenz zeigt, in die Absorberschicht hinein zu diffundieren.

Anstelle oder zusammen mit dem Zn(TFSI)₂ liegen beispielsweise auch Bi-(3,5-TFMBZ)3, Bismut(III) tris (3,5-bistrifluormethyl)benzoat, Bi(4-pFbz)₃, Bismut (III) tris(4-pentafluoro)benzoat, K(TFSI), K(I)bis(trifluoromethanesulfonyl)imide und/oder Zn(II)bis (trifluoromethanesulfonyl)imide und/oder Natrium(I)bis(trifluoromethanesulfonyl)imid als Dotierungsmittel vor.

Darüber hinaus können auch Tri-Fluormethan-sulfonate wie Zn (TFMS)₂ vorteilhaft als Dotiermittel eingesetzt werden. Alternativ oder ergänzend können auch sogenannte Ionische Flüssigkeiten "Ionic liquids" als effektive Dotiermittel genutzt werden.

Abschließend befindet sich auf der Lochleiterschicht 4 noch die Gegenelektrode, beispielsweise aus Aluminium, Silber und/oder Gold.

Der gesamte Aufbau ist bevorzugt durch eine Verkapselung 6 vor Feuchte und/oder Luft geschützt.

Figur 2 zeigt den Anstieg der Leerlaufspannung einer metallorganischen Solarzelle beim Wechsel von einer mit Lithium dotierten Lochleiterschicht zu einer mit Zink dotierten Lochleiterschicht.

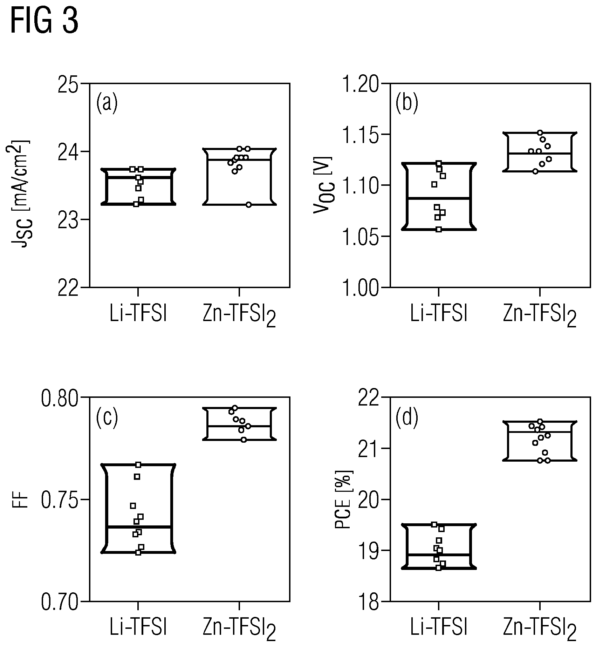

Figur 3 zeigt vier verschiedene charakteristische photovoltaische Parameter (JSC (Kurzschlussstrom), VOC (Leerlaufspannung), FF (Füllfaktor)und PCE (photo current efficiency (Fotostromeffizienz)) von Perowskit Solarzellen. Hier im Vergleich zwischen einer Perowskit Solarzelle mit spiro-MeOTAD /LiTFSI (schwarz) und spiro-MeOTAD /Zn(TFSI)2 (rot) als Lochleiterschicht.

Diese Messungen zeigen jeweils die metallorganischen Solarzellen mit Lithium-dotierten und Zink dotierten Lochleiterschichten bei ansonsten gleichem Aufbau und Messbedingungen im Vergleich. So machen diese Messungen deutlich, dass die mit einer Zink dotierten Lochleiterschicht aufgebauten Solarzellen den mit herkömmlichem Lithium dotierten zumindest gleichwertig sind. Dies ist umso erstaunlicher, als die Dotierungskonzentration vom Lithium zum Zink und/oder Bismut deutlich sinkt, was einen deutlichen wirtschaftlichen Vorteil bringt.

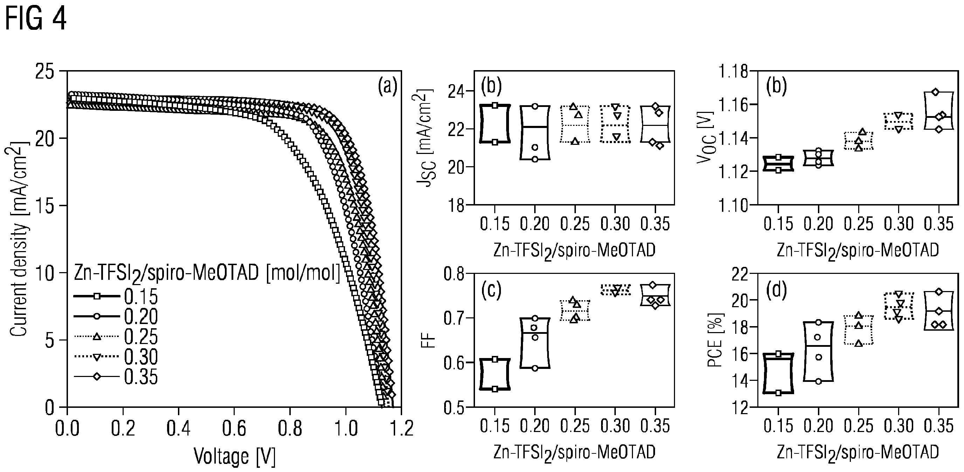

Figur 4 zeigt Messung einzelner Lochleiterschichten ohne Solarzellenaufbau. Zu erkennen ist in der Figur die Stromdichte verschiedener Dotierungskonzentrationen bei verschiedenen Spannungen mit dem Ergebnis, dass ab 0,2 mol Dotierungsmittel pro mol Matrixverbindung offensichtlich keine signifikante Steigerung der Stromdichte durch Erhöhung der Dotierungskonzentration mehr möglich ist.

In Figur 4 sind neben den Strom-Spannungskurven, die links zu sehen sind, noch rechts die entsprechenden photovoltaischen Parameter wie JSC, VOC, FF und PCE in Abhängigkeit der Konzentration des Dotiermittels Zn (TFSI)₂ im Matrixmaterial Spiro-MeOTAD.

Dabei fällt vor allem auf, dass der "Fill Faktor" (Füllfaktor) signifikant verbessert wurde. Der Füllfaktor bezeichnet den Quotienten aus der maximalen Leistung einer Solarzelle am Maximum Power Point und dem Produkt aus Leerlaufspannung und Kurzschlussstrom.

Im Ganzen ergibt das Ergebnis der Messungen, dass die mit einer Lochleiterschicht mit dem erfindungsgemäßen Dotierungsmittel auf Zink- und/oder Bismut-Basis aufgebauten metallorganischen Solarzellen mit einer Absorberschicht aus einem in der dreidimensionalen Perowskit-Struktur kristallisierenden Material eine sehr gute Effizienz der Licht in Elektrizitäts-Umwandlung zeigen.

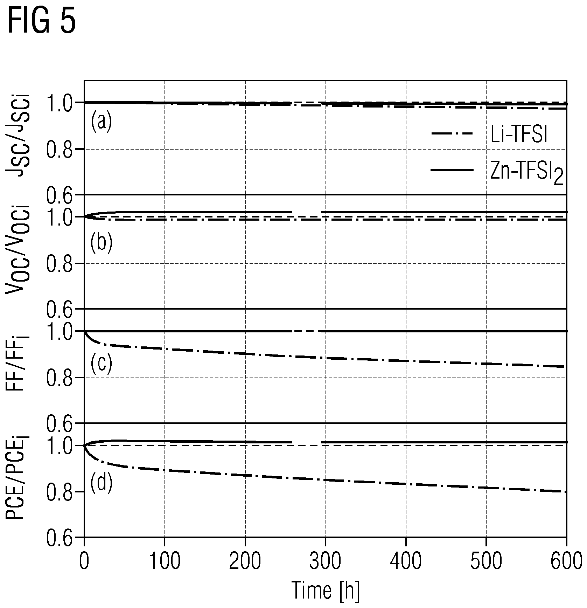

In Figur 5 schließlich wird die Stabilität der mit Zink einerseits und mit Lithium andererseits hergestellten Lochleiterschichten verglichen. Es zeigt sich, dass die herkömmlichen, mit Lithium dotierten Lochleiterschichten weit weniger stabil sind als die entsprechenden Lochleiterschichten mit Zink und/oder Bismut. Das hängt unter anderem damit zusammen, dass das kleine Lithium-Ion natürlich unter Temperaturerhöhung und/oder im elektrischen Feld leichter und schneller diffundiert und damit die Homogenität der Lochleiterschichten herabsetzt. Insbesondere bei der PCE - Power Conversion Efficiency - /PCE-Messung zeigt sich deutlich, wie mit steigender Stundenzahl die Effizienz der mit Lithium dotierten Lochleiterschicht nachlässt.

Die vorliegende Erfindung offenbart erstmals eine metallorganische Solarzelle, eine Absorberschicht mit einer im Perowskit-Kristallgitter kristallisierenden Verbindung umfassend, die eine Lithium-arme Lochleiterschicht aufweist.

## Patentansprüche

1. Metallorganische Solarzelle, zumindest zwei Kontaktschichten (5,7), wobei eine Kontaktschicht als Anode (5) ausgebildet ist, und daran angrenzend jeweils eine halbleitende Schicht (2,4) in einem Schicht-Stapel mit einer mittig angeordneten Absorberschicht (3) aus einem metallorganischen Material, das im dreidimensionalen Perowskit-Kristallgitter kristallisiert, aufweisend, wobei die Absorberschicht (3) Blei als Zentralatom und ein Halogenid als Anion in einer metallorganischen Verbindung umfasst, **dadurch gekennzeichnet, dass** die zumindest eine halbleitende Schicht (4) zwischen der Absorberschicht (3) und der Anode (5) eine lochleitende Schicht ist, die ein Zink-haltiges Dotierungsmittel umfasst.

2. Metallorganische Solarzelle, zumindest zwei Kontaktschichten (5,7), wobei eine Kontaktschicht als Anode (5) ausgebildet ist, und daran angrenzend jeweils eine halbleitende Schicht (2,4) in einem Schicht-Stapel mit einer mittig angeordneten Absorberschicht (3) aus einem metallorganischen Material, das im dreidimensionalen Perowskit-Kristallgitter kristallisiert, aufweisend, wobei die Absorberschicht (3) Zinn als Zentralatom und ein Halogenid als Anion in einer metallorganischen Verbindung umfasst, **dadurch gekennzeichnet, dass** die zumindest eine halbleitende Schicht (4) zwischen der Absorberschicht (3) und der Anode (5) eine lochleitende Schicht ist, die ein Bismut-haltiges Dotierungsmittel umfasst.

3. Solarzelle nach einem der Ansprüche 1 oder 2, wobei im Dotierungsmittel die Zink- oder Bismut-Verbindung das Salz einer Supersäure ist.

4. Solarzelle nach einem der Ansprüche 1 bis 3, wobei die Solarzelle eine Diffusionssperrschicht zwischen der Absorberschicht und einer halbleitenden Schicht umfasst.

5. Solarzelle nach Anspruch 4, wobei die Diffusionssperrschicht eine Schichtdicke von kleiner 150nm aufweist.

6. Solarzelle nach einem der Ansprüche 1 bis 5, die im Matrixmaterial der Lochleiterschicht eine oder mehrere Verbindungen, ausgewählt aus der Gruppe folgender Verbindungen:
spiro-OMeTAD - 2,2'7,7'-tetrakis-(N, N-di-p-methoxyphenylamine)9,9'-spirobifluorene,
PEDOT - poly(3,4 ethylenedioxythiophene),
PVK - poly(9-vinylcarbazole),
PTPD - poly(N.N₋bis(4-butylphenyl)-N,N-bis(phenyl)-benzidine),
P3HT - poly(3-hexylhtiophene),
PANI - polyaniline,
PTAA - Poly[bis(4-phenyl)(2,4,6-trimethylphenyl)amine], 9,9-Bis[4-(N,N-bis-biphenyl-4-yl-amino)phenyl]-9H-fluorene, 4,4',4"-Tris(N-(2-naphthyl)-N-phenyl-amino)triphenylamine und/oder ionische Flüssigkeiten, sowie Mischungen der oben genannten Verbindungen, umfasst.

7. Solarzelle nach einem der Ansprüche 1 bis 6, wobei die Absorberschicht einen Metallkomplex mit Zinn und/oder Blei als Zentralatom umfasst, der mindestens ein Anion in Form eines Halogenids oder Pseudohalogenids, ausgewählt aus der Gruppe der folgenden Elemente: Fluorid, Chlorid, Bromid, Jodid, Cyanid, Isocyanid, enthält.

8. Solarzelle nach einem der Ansprüche 1 bis 7, wobei die Absorberschicht einen Metallkomplex mit Zinn und/oder Blei als Zentralatom umfasst, an dem ein (CH₃NH₃)⁺- Ligand koordiniert vorliegt.

9. Tandem-Solarzelle, zumindest zwei aufeinander aufbauende Solarzellen in einem Schicht-Stapel umfassend, wobei eine Solarzelle eine metallorganische Solarzelle nach einem der Ansprüche 1 bis 8 ist.

10. Tandem-Solarzelle nach Anspruch 9, wobei die metallorganische Solarzelle nach einem der Ansprüche 1 bis 9 die obere Solarzelle, auf die die Photonen als erstes auftreffen, ist.

11. Tandem-Solarzelle nach einem der Ansprüche 9 oder 10, die eine Solarzelle mit kristallinem Silizium in der Absorberschicht umfasst.

12. Tandemzellen nach einem der Ansprüche 9 bis 11, die zwei metallorganische Solarzellen nach einem der Ansprüche 1 bis 8 umfasst, wobei die beiden Solarzellen sich in der Zusammensetzung des Materials, das die Absorberschicht bildet, unterscheiden.

13. Verfahren zur Herstellung eines Schichtkörpers, eine Tandem-Solarzelle bildend, bei dem ein Schichtstapel zwei Solarzellen umfassend durch Schichtabscheidung im nasschemischen Verfahren herstellbar ist, wobei eine untere und eine obere Solarzelle durch die Herstellung aufeinander folgender Schichten hergestellt werden, **dadurch gekennzeichnet, dass** eine der Solarzellen eine metallorganische Solarzelle nach einem der Ansprüche 1 bis 8 ist.

## Claims

1. Metal-organic solar cell having at least two contact layers (5,7), wherein one contact layer is an anode (5), and, adjoining these, in each case a semiconducting layer (2,4) in a layer stack having a centrally arranged absorber layer (3) composed of a metal-organic material which crystallizes in the three-dimensional perovskite crystal lattice, where the absorber layer (3) comprises lead as central atom and a halide as anion in a metal-organic compound, **characterized in that** the at least one semiconducting layer (4) between the absorber layer (3) and the anode (5) is a hole-conducting layer which comprises a zinc-containing dopant.

2. Metal-organic solar cell having at least two contact layers (5,7), wherein one contact layer is an anode (5), and, adjoining these, in each case a semiconducting layer (2,4) in a layer stack having a centrally arranged absorber layer (3) composed of a metal-organic material which crystallizes in the three-dimensional perovskite crystal lattice, where the absorber layer (3) comprises tin as central atom and a halide as anion in a metal-organic compound, **characterized in that** the at least one semiconducting layer (4) between the absorber layer (3) and the anode (5) is a hole-conducting layer which comprises a bismuth-containing dopant.

3. Solar cell according to either Claim 1 or 2, wherein the zinc or bismuth compound in the dopant is the salt of a superacid.

4. Solar cell according to any of claims 1 to 3, wherein the solar cell comprises a diffusion barrier layer between the absorber layer and a semiconducting layer.

5. Solar cell according to Claim 4, wherein the diffusion barrier layer has a layer thickness of less than 150 nm.

6. Solar cell according to any of Claims 1 to 5 which in the matrix material of the hole conductor layer comprises one or more compounds selected from the group consisting of the following compounds:
spiro-OMeTAD - 2,2',7,7'-tetrakis(N,N-di-p-methoxyphenylamine)-9,9'-spirobifluorene,
PEDOT - poly(3,4-ethylenedioxythiophene),
PVK - poly(9-vinylcarbazole),
PTPD - poly(N,N-bis(4-butylphenyl)-N,N-bis(phenyl)benzidine),
P3HT - poly(3-hexylthiophene),
PANI - polyaniline,
PTAA - poly[bis(4-phenyl)(2,4,6-trimethylphenyl)amine], 9,9-bis[4-(N,N-bis-biphenyl-4-yl-amino)phenyl]-9H-fluorene, 4,4',4"-tris(N-(2-naphthyl)-N-phenyl-amino)triphenylamine and/or ionic liquids, and also mixtures of the abovementioned compounds.

7. Solar cell according to any of Claims 1 to 6, wherein the absorber layer comprises a metal complex having tin and/or lead as central atom which contains at least one anion in the form of a halide or pseudohalide, selected from the group of the following elements: fluoride, chloride, bromide, iodide, cyanide, isocyanide.

8. Solar cell according to any of Claims 1 to 7, wherein the absorber layer comprises a metal complex having tin and/or lead as central atom to which a (CH₃NH₃)⁺ ligand is coordinated.

9. Tandem solar cell comprising at least two superposed solar cells in a layer stack, wherein one solar cell is a metal-organic solar cell according to any of Claims 1 to 8.

10. Tandem solar cell according to Claim 9, wherein the metal-organic solar cell according to any of Claims 1 to 9 is the upper solar cell on which the photons impinge first.

11. Tandem solar cell according to either Claim 9 or 10 which comprises a solar cell having crystalline silicon in the absorber layer.

12. Tandem cell according to any of Claims 9 to 11 which comprises two metal-organic solar cells according to any of Claims 1 to 8, wherein the two solar cells differ in terms of the composition of the material which forms the absorber layer.

13. Process for producing a layer body forming a tandem solar cell, in which a layer stack comprising two solar cells can be produced by layer deposition in a wet-chemical process, where a lower solar cell and an upper solar cell are produced by the production of sequential layers, **characterized in that** one of the solar cells is a metal-organic solar cell according to any of Claims 1 to 8.

## Revendications

1. Pile solaire organométallique, comprenant au moins deux couches (5, 7) de contact, dans laquelle une couche de contact est constituée en anode (5),
et, en étant voisine respectivement, une couche (2, 4) semiconductrice d'un empilement de couches ayant une couche (3) absorbante au milieu en un matériau organométallique, qui cristallise dans le réseau cristallin perovskite tridimensionnel, dans laquelle la couche (3) absorbante comprend du plomb comme atome central et un halogénure comme anion dans un composé organométallique, **caractérisé en ce que** la au moins une couche (4) semiconductrice entre la couche (3) absorbante et l'anode (5) est une couche de conduction par trou, qui comprend un agent de dopage contenant du zinc.

2. Pile solaire organométallique, comprenant au moins deux couches (5, 7) de contact, dans laquelle une couche de contact est constituée en anode (5),
et, en étant voisine respectivement, une couche (2, 4) semiconductrice d'un empilement de couches ayant une couche (3) absorbante au milieu en un matériau organométallique, qui cristallise dans le réseau cristallin perovskite tridimensionnel, dans laquelle la couche (3) absorbante comprend de l'étain comme atome central et un halogénure comme anion dans un composé organométallique, **caractérisé en ce que** la au moins une couche (4) semiconductrice entre la couche (3) absorbante et l'anode (5) est une couche à conduction par trou, qui comprend un agent de dopage contenant du bismuth.

3. Pile solaire suivant l'une des revendications 1 ou 2, dans laquelle l'agent de dopage composé du zinc ou du bismuth est le sel d'un peracide.

4. Pile solaire suivant l'une des revendications 1 à 3, dans laquelle la pile solaire comprend une couche formant barrière de diffusion entre la couche absorbante et une couche semiconductrice.

5. Pile solaire suivant la revendication 4, dans laquelle la couche formant barrière de diffusion a une épaisseur de couche plus petite que 150 nm.

6. Pile solaire suivant l'une des revendications 1 à 5, qui comprend, dans la matière de matrice de la couche de la conduction par trou, un ou plusieurs composés choisis dans le groupe des composés suivants :
spiro-OMeTAD - 2,2',7,7'-tétrakis-(N, N-di-p-méthoxyphénylamine) 9,9'-spirobifluorène,
PEDOT - poly(3,4 éthylènedioxythiophène),
PVK - poly(9-vinylcarbazole),
PTPD - poly(N.N-bis(4-butylphényl)-N,N-bis(phényl - benzidine),
P3HT - poly(3-hexylthiophène),
PANI - polyaniline,
PTAA - Poly[bis(4-phényl)(2,4,6-triméthylphényl)amine],9,9-Bis[4-(N, N-bis-biphényl-4-yl-amino)phényl)]-9H-fluorène, 4,4',4"-Tris(N-(2-naphtyl)-N-phényl- amino)triphénylamine,
et / ou des liquides ioniques ainsi que des mélanges des composés mentionnés ci-dessus.

7. Pile solaire suivant l'une des revendications 1 à 6, dans laquelle la couche absorbante comprend un complexe métallique ayant de l'étain et/ou du plomb comme atome central, qui contient au moins un anion sous la forme d'un halogénure ou d'un pseudo-halogénure choisi dans le groupe des éléments suivants : fluorure, chlorure, bromure, iodure, cyanure, isocyanure.

8. Pile solaire suivant l'une des revendications 1 à 7, dans laquelle la couche absorbante comprend un complexe métallique ayant de l'étain et/ou du plomb comme atome central, auquel est coordinné un ligand- (CH₃NH₃)⁺.

9. Pile solaire tandem comprenant au moins deux piles solaires mises l'une sur l'autre en un empilement de couches, dans laquelle une pile solaire est une pile solaire organométallique suivant l'une des revendications 1 à 8.

10. Pile solaire tandem suivant la revendication 9, dans laquelle la pile solaire organométallique suivant l'une des revendications 1 à 9 est la pile solaire supérieure, sur laquelle les photons arrivent en premier.

11. Pile solaire tandem suivant l'une des revendications 9 ou 10, qui comprend une pile solaire ayant du silicium cristallin dans la couche absorbante.

12. Pile solaire tandem suivant l'une des revendications 9 à 11, qui comprend deux piles solaires organométalliques suivant l'une des revendications 1 à 8, dans laquelle les deux piles solaires sont différentes dans la composition de la matière, qui forme la couche absorbante.

13. Procédé de préparation d'un corps stratifié, formant une pile solaire tandem, dans lequel un empilement de couches, comprenant deux piles solaires, peut être produit par dépôt de couches dans un procédé chimique en voie humide, dans lequel on prépare une pile solaire inférieure et une pile solaire supérieure par la production de couches se succédant l'une sur l'autre, **caractérisé en ce que** l'une des piles solaires est une pile solaire organométallique suivant l'une des revendications 1 à 8.
